# EUROPEAN PATENT SPECIFICATION

(11) **EP 2 962 335 B1**
(45) Date of publication and mention of the grant of the patent: **28.04.2021**
(21) Application number: 14709435.3
(22) Date of filing: 03.03.2014
(51) Int. Cl.: H01L 31/068, H01L 31/0224

(54) **PHOTO-VOLTAIC CELL AND METHOD OF MANUFACTURING SUCH A CELL**
PHOTOVOLTAIKZELLE UND VERFAHREN ZUR HERSTELLUNG SOLCH EINER ZELLE
CELLULE PHOTOVOLTAÏQUE ET PROCÉDÉ DE FABRICATION D'UNE TELLE CELLULE

(30) Priority: 01.03.2013 NL 2010382
(43) Date of publication of application: 06.01.2016
(73) Proprietor: Stichting Energieonderzoek Centrum Nederland, 1755 LE Petten (NL)
(72) Inventor: CESAR, Ilkay, 1755 LE Petten (NL); BURGERS, Antonius Radboud, 1755 LE Petten (NL)
(74) Representative: V.O.
(86) International application number: PCT/NL2014/050128
(87) International publication number: WO 2014/133392

(56) References cited:
- US-A- 4 133 698
- US-A- 4 665 277
- US-A1- 2004 200 520
- US-A1- 2009 227 097
- US-B1- 7 339 110
- FILIP GRANEK ET AL: "Enhanced lateral current transport via the front N + diffused layer of n-type high-efficiency back-junction back-contact silicon solar cells", PROGRESS IN PHOTOVOLTAICS: RESEARCH AND APPLICATIONS, vol. 17, no. 1, 1 January 2009 (2009-01-01), pages 47-56, XP055026964, ISSN: 1062-7995, DOI: 10.1002/pip.862
- J. ROBBELEIN ET AL.: "Industrial type passivation on Interdigitated Back Junction solar cells", 24TH EUROPEAN PHOTOVOLTAIC SOLAR ENERGY CONFERENCE AND EXHIBITION ; 21 - 25 SEPTEMBER 2009, HAMBURG, GERMANY ; PROCEEDINGS ; EU PVSEC, WIP-RENE, 21 September 2009 (2009-09-21), pages 1992-1996, XP040530123, ISBN: 978-3-936338-25-6
- J. ROBBELEIN ET AL.: "Towards advanced back surface fields by boron implantation on p-type interdigitated back junction solar cells", EU PVSEC PROCEEDINGS : 25TH EUROPEAN PHOTOVOLTAIC SOLAR ENERGY CONFERENCE AND EXHIBITION / 5TH WORLD CONFERENCE ON PHOTOVOLTAIC ENERGY CONVERSION, 6-10 SEPTEMBER 2010, VALENCIA, SPAIN, MUNICH, DE, 6 September 2010 (2010-09-06), pages 2014-2018, XP040531133, ISBN: 978-3-936338-26-3
- H. HAVERKAMP ET AL.: "Screen printed interdigitated back contact solar cells with laser fired contacts", 21ST EUROPEAN PHOTOVOLTAIC SOLAR ENERGY CONFERENCE : PROCEEDINGS OF THE INTERNATIONAL CONFERENCE HELD IN DRESDEN, GERMANY, 4 - 8 SEPTEMBER 2006, WIP RENEWABLE ENERGIES, MÜNCHEN, 4 September 2006 (2006-09-04), pages 1432-1435, XP040512462, ISBN: 978-3-936338-20-1 cited in the application

## Description

### Field of the invention

The invention relates to a back contact solar cell, and more generally photo-voltaic cells, with base and emitter regions at the back surface of the cell, i.e. at the surface that will be directed way from the sun, and a front floating emitter layer at the front surface.

### Background

It is known to passivate the front surface of such a photo-voltaic cell by using a front floating emitter (FFE). Electrical passivation of a surface comprises the suppression of recombination losses at or near surfaces. A front floating emitter (FFE) is a non-contacted, electrically floating layer at the front surface of the semi-conductor substrate of the photo-voltaic cell with the same doping type as the emitter, i.e. opposite doping type relative to the bulk of the substrate. A cell with such a passivation is known for example from an article by H. Haverkamp et al, titled "Screen printed interdigitated back contact solar cells with laser fired contacts", Proceedings, EU-PVSEC 2006 Dresden.

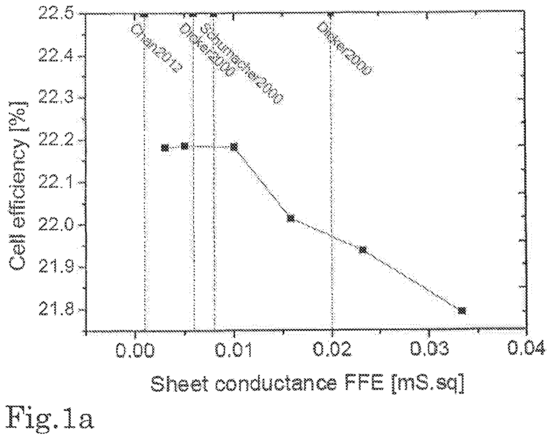

The front floating emitter (FFE) provides for passivation by reducing the product of the densities of positive and negative mobile charge carriers at the surface, so that contributions to the recombination rates that depend on that product are reduced. However, other recombination mechanisms like Auger recombination increase with increased doping level in the doping profile that provides for the increased doping level at the surface. Hence, the doping level of the FFE is a compromise. Figure 1a illustrates this by means of a plot of solar cell efficiency, , as a function of doping level, represented by the dark electrical conductivity of the FFE, for a typical prior art solar cell design. This electrical conductivity is a measure of doping level, because it depends on the density of free charge carriers. The efficiency (eta) is a ratio of electrical output power to incoming solar light power. For very small doping levels (not shown) the efficiency drops due to decreased suppression of minority charge carrier density at the surface. The drop in efficiency for higher doping levels is the result of recombination processes like Shockley-Read-Hall and Auger recombination. Electrical conductivity values from a number of prior art publications have been indicated in this figure (Dicker et. al "Analysis of rear contacted solar cell structures for cost-effective processes and materials", Proceedings IEEE_PVSC_2000 page numbers 387-390, Schumacher J.O. Schumacher, "Numerical simultation of silicon solar cells with novel cell structures", Ph.D. Thesis 2000 University of Konstanz page number 136, Chan "Simplified interdigitated back contact solar cells", Silicon PV 2012, Energy Procedia 27 (2012) pages 543 - 548). The sub-optimal outlying value is an inference from an example from Dicker where, for reasons of simplifying the processing, a front floating emitter with the same electrical conductivity as the back surface as used.

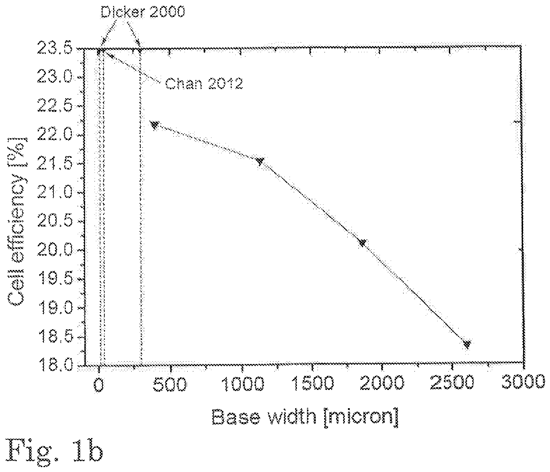

Unlike the front surface, the back surface of such a back contact photo-voltaic cell needs to contain base regions (or more specifically back surface field regions) in addition to emitter regions with contacts on the base and emitter regions. Base regions have net doping of the same electrical conductivity type as the substrate and emitter regions have net doping of the opposite electrical conductivity type. Back surface field regions have enhanced doping compared to the substrate. Typically, interdigitated strip shaped regions are used, forming alternate base and emitter strips regions. Because of electrical shading efficiency depends on the width of the base strips. Figure 1b illustrates efficiency as a function of base strip width for a typical solar cell. Conventionally, narrow base strips are used to obtain optimal efficiency. The widths used by Dicker and Chan are indicated in figure 1b by way of example.

Although the narrow width prevents the loss of efficiency due to electrical shading, this comes at a price. The narrow width of the base regions increases processing costs, because it imposes strict manufacturing tolerances. Furthermore, the narrower the width, the more base (back surface field))-emitter pairs are needed on the back surface, which also decreases efficiency. Also the difference between the widths of the base and emitter regions may make it necessary to use different electrode designs, which also complicates manufacturing.

US 7,339,110 discloses a solar cell with interdigitated back surface field regions and emitter regions printed on the back surface. Cells with a floating front surface field are described extensively, but the possibility of using a front floating emitter is mentioned as well. In an example with a floating front surface field, emitter regions with a width of 0.7 millimeters are used. US 7,339,110 mentions a number alternatives for the floating front surface field, including a floating junction on the front surface, to provide for good passivation of the silicon-silicon dioxide interface on the front surface. A sheet resistivity of 100 Ohms per square (10 milliSiemens square) is disclosed as an example for this floating junction layer.

Granek et al. discuss enhanced lateral current transport via a front surface field layer of a solar cell in an article titled "Enhanced Lateral Current Transport Viat the Front N+ Diffused Layer of N-type High-efficiency Back-junction Back-contact Silicon Solar Cells", published in Prog.Photovolt: Res Appl. 2009. 17:47-56.

### Summary

Among others, it is an object to provide for a more efficient photo-voltaic cell wherein wider base regions are used on the back surface.

A photo-voltaic cell according to claim 1 is provided. Herein back surface field regions with a width of more than 0.6 millimeter and more preferably more than 0.75, 0.8 or even more than one millimeter are used. Preferably, a front floating emitter layer with an average electrical conductivity value much higher than needed for minimizing surface recombination is used, selected dependent on the width of the back surface field regions. It has been found that use of such an average electrical conductivity value in the front floating emitter layer can be used to realize wide back surface field regions without a strong loss of efficiency. In an embodiment, the front floating emitter layer may extend continuously in the lateral directions of the front surface. Alternatively, it may be interrupted, e.g. to form regions over the back surface field regions, or a front floating emitter pattern over the back surface field regions to the edges of the over the back surface field regions.

Preferably, the average electrical conductivity of the front floating emitter layer is at least an electrical conductivity value C =a*W-b, wherein W is the width of the back surface field region in millimeter, with coefficients a=5.54 milliSiemens square/millimeter and b=1.0 milliSiemens square. Preferably the average front floating emitter layer sheet conductance is less than 25 milliSiemens square.

Preferably the bulk of semi-conductor substrate (also called the base) has n-type electrical conductivity type. Preferably sheet resistance of the bulk is at least 138 Ohm per square, for example 2 Ohm centimeter for a 145 micrometer thick wafer.

In an embodiment, the photo-voltaic cell comprises first conductors on the back surface field regions and second conductors on the back surface emitter regions, the first and second conductors having substantially equal width. This may be used to minimize the costs of providing the conductors.

In an embodiment, back surface field regions at the back surface of the substrate with a same width as the back surface emitter areas are used. This may be used to simplify the layout. Preferably the back surface emitter areas with widths between 0.2 and 2 of the width of the back surface field regions, and preferably between 0.5 and 1.5. Small widths of the surface emitter areas decrease efficiency. The emitter width may be selected to optimize efficiency.

In the invention, the photo-voltaic cell comprises a front surface field layer abutting the front surface of the substrate, the floating front emitter layer lying between the front surface field layer and the substrate. The front surface field layer is a layer with the same conductivity type as the bulk of the substrate, i.e. a conductivity type opposite to that of the front floating emitter layer. During manufacturing, these layers may be realized for example by using successive doping steps for the front floating emitter layer and the floating front surface field layer. In this embodiment the floating front surface field layer functions to reduce of surface recombination and the front floating emitter layer functions to provide lateral transport of photo-generated minority charge carriers from the substrate (these being majority charge carriers in the front floating emitter layer). By separating these functions a higher efficiency can be realized.

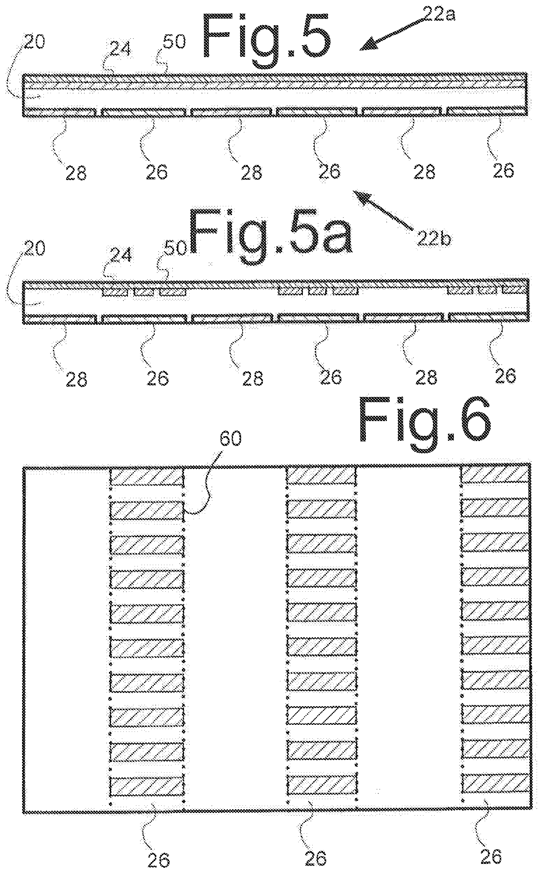

Preferably, the front floating emitter above the base contains openings (as illustrated in figure 5a) containing semi-conductor material with the same conductivity type as the front surface field layer (or metal) to facilitate vertical majority charge carrier transport. If a front floating emitter is present above the emitter it preferably contains similar openings.

In a further embodiment, conductive connections through the front floating emitter layer from the front floating surface field layer to the bulk of the substrate. This increases efficiency by helping to transport majority charge carriers from the bulk of the substrate above the back surface emitter regions to locations over the back surface field regions, via the front floating surface field layer. These conductive connections may be quite small, for example with a diameter of no more than twice a diffusion length of the minority charge carriers in the bulk of the substrate.

Preferably conductive connections are also provided in the front floating emitter layer above the back surface emitter regions. These openings may extend over substantially the entire back surface emitter regions. This promotes collection of majority charge carriers from the bulk of the substrate to the front floating surface field layer. In a preferred embodiment the front floating surface field layer extends over all positions over the back surface emitter regions. But an improvement may already be realized if the front floating surface field layer extends over part of the back surface field region or to a position over its edge.

In an embodiment, the front floating emitter layer has parts with a relatively high first electrical conductivity and parts with relatively low second electrical conductivity. The second electrical conductivity may be optimized to minimize surface recombination and the first electrical conductivity may be used to realize more than a threshold average surface electrical conductivity above the back surface field regions.

This may be used to optimize efficiency. The parts with the first electrical conductivity preferably extend from the locations above a center of the back surface field regions to its edges. An A or any layout pattern may be used for the parts with the first electrical conductivity, such as a set of parallel lines. The combined use of parts with higher and lower conductivity may even make it possible to use a lower average conductivity than for a front floating emitter layer with constant conductivity.

In an embodiment, the front floating emitter layer is provided only over the back surface field regions, or it may have a lower second electrical conductivity value over the back surface emitter regions than a first electrical conductivity over the back surface field regions. The second electrical conductivity may be optimized to minimize surface recombination and the first electrical conductivity may be used to realize more than a threshold average surface electrical conductivity above the back surface field regions. This may be used to optimize efficiency..

The photo-voltaic cell according to any one of the preceding claims, wherein the front floating emitter layer comprises first regions of relatively higher first electrical conductivity value selected dependent on the width of said one of the back surface field regions and second regions of relatively lower second electrical conductivity value, the first regions extending from positions over said one of the back surface field regions at least substantial to an edge of said one of the back surface field regions or beyond the edge. For the purpose of selecting the average electrical conductivity of the front floating emitter layer the higher first electrical conductivity value may be selected, alternatively an average of the first and second electrical conductivities may be selected.

### Brief description of the drawing

These and other advantages and objects will become apparent from a description of exemplary embodiments, by reference to the following figures.
Figure 1a shows a plot of cell efficiency as a function of FFE electrical conductivity
Figure 1b shows a plot of cell efficiency as a function of base width
Figure 2 shows a schematic cross section (not to scale) of a photo-voltaic cell not part of the invention
Figure 3 shows a part of the back surface of a photo-voltaic cell not part of the invention
Figure 4, 4a show plots of cell efficiency as function of FFE electrical conductivity
Figures 4b-d show contour plots with contours of constant efficiency values
Figure 5, 5a show schematic cross sections of a photo-voltaic cell
Figure 6, 6a, 7 shows a part of a front surface of photo-voltaic cells Detailed description of exemplary embodiments.

Shading loss occurs in a photovoltaic cell with base regions (or more specifically back surface field regions) and emitter regions on the back surface and a front surface field or no special semi-conductor layer at the front surface and with contacts on the base and emitter regions. When current is drawn from the photovoltaic cell, the current through the emitter regions is a result of photo-excitation of minority charge carriers, mainly in the substrate. The minority charge carriers excited above the emitter regions flow vertically to the emitter regions below, but minority charge carriers excited above the base regions need to flow laterally to the emitter regions. The decreasing efficiency of the cell with increasing width of such photo-voltaic cells corresponds to the effect that for minority charge carriers excited at positions above a base region, the fraction of the minority charge carriers excited at the position that will be lost to recombination increases with distance of the position to the nearest edge of the base region. At positions far from the nearest edge this fraction approaches one. Apart from surface recombination effects, this bulk recombination effect of minority charge carriers that flow laterally is substantially the same for cells with front surface field regions and front emitter regions and cells without a special front surface.

Therefore, the usual design criterion for the width of the base regions in such photovoltaic cells with interdigitated back surface field and emitter regions is that the back surface field regions (base regions) are just so wide that no significant shading loss occurs when a short circuit or optimal power point output current is drawn. That is, contemplating a position above the back surface field region that is furthest from the nearest emitter region (e.g. the centre midway between emitter regions adjacent the back surface field region), the design criterion ensures that the fraction of those minority charge carriers that are excited at that position due to recombination for minority charge carriers is e.g. less than a predetermined value of e.g. 90% and preferably less than half for minority charge carriers generated above the centre of the back surface field region.

In practice this comes down to a maximum contemplated width of the base regions (back surface field regions) of less than 0.6 millimeter in solar energy production cells.

The present invention uses larger widths and more preferably more than 0.75, 0.8 or even more than one millimeter. A width may be used at which minority charge carrier loss due to recombination for minority charge carriers flowing laterally through the substrate semi-conductor above the back surface field region would be e.g. more than 90% or more than half of the minority charge carriers generated above the centre of the back surface field region if a front surface field region or no special semi-conductor region would be used at the front surface above the substrate.

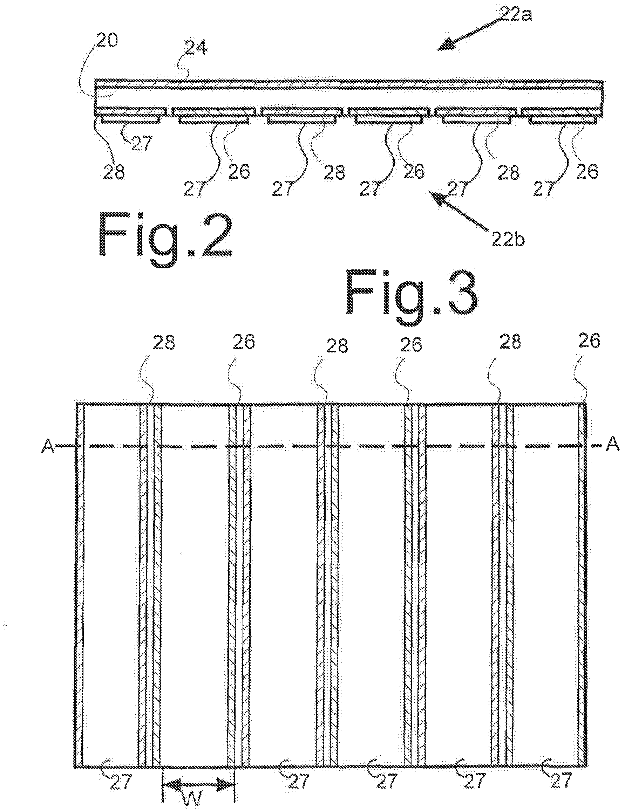

Figure 2 shows a schematic cross section (not to scale) of a photo-voltaic cell not part of the invention comprising a semi-conductor substrate 20, with a planar front surface 22a and a planar back surface 22b. The bulk of semi-conductor substrate 20 (also called the base) has a first electrical conductivity type, preferably n-type. A silicon substrate may be used for example. In semi-conductor substrate 20 adjacent to front surface 22a a front floating emitter layer 24 is provided, i.e. a layer of a second electrical conductivity type, opposite to the first electrical conductivity type (for example a p-type emitter when the substrate is n-type). In semi-conductor substrate 20 adjacent to back surface 22b alternating back surface field regions 26 and emitter regions 28 are provided. Optionally, there may be a distance (a gap) between the edges of field back surface field regions 26 and emitter regions 28, formed for example by cutting trenches between these regions, or by a surface part where no doping has been added to form back surface field regions 26 and emitter regions 28. A back surface field region plus the optional gaps on both sides will be referred to as a base. Thus, the base width includes the width of the back surface field and the gaps. Conductor tracks 27 are provided on back surface field regions 26 and emitter regions 28, forming electrodes for these regions. Base regions 26 have enhanced doping of the first electrical conductivity type compared to the substrate. Emitter regions 28 have doping of the second electrical conductivity type. In practice, the cell will contain other structures (not shown) such as isolation layers, electrodes etc. For example an anti reflection coating layer (or layer set) may be provided on the front surface of substrate 20. Such a layer may comprise a part in contact with substrate 20 that reduced recombination centres (chemical passivation), and the layer may have a space charge that reduces carrier density at the surface of substrate. If a p-type layer is present in the substrate 20 at the top surface Al2O3 may be used in the coating layer and SiNx may be used in the case of n-type. As illustrated the front surface may be planar. Alternatively, it may be textured, e.g. with valleys and pyramid shaped protrusions.

As used herein "floating" is used for electrically floating, i.e. without substantial electrical connection of the front floating emitter layer to the back surface field regions 26 and emitter regions 28 other than by the bulk of substrate 20. As will be described, a front surface field layer may be provided between the front floating emitter layer 24 and front surface 22a. Both in this case and the case that front floating emitter layer 24 reaches to front surface 22a, the front floating emitter layer 24 will be said to lie at front surface 22a.

Back surface field regions 26 and emitter regions 28 may be realized by providing for diffusion and/or implantation of doping into the back surface of semi-conductor substrate 20, or as added doped material on that back surface, so that the emitter regions form hetero junctions at the contact with semi-conductor substrate 20. Such areas in or on semi-conductor substrate 20 will be referred to as areas at the surface of semi-conductor substrate 20.

An isolating layer (not shown) may be provided between conductor tracks 27 on one hand and back surface field regions 26 and emitter regions 28 on the other hand, with electrical connections through the isolating layer to the back surface field regions 26 and emitter regions 28 at a part of the conductor tracks 27. Contact between conductor tracks 27 and back surface field regions 26 and emitter regions 28 may lead to increased recombination. But by using electrical connections through the isolating layer only at a fraction of the total area of conductor tracks 27, efficiency can be optimized independent of the width of conductor tracks 27.

Having wide tracks has the advantage that it reduces the time needed for obtaining a desired conductor track conductivity by depositing conductor tracks 27 using an incremental deposition processes such as sputtering or plating. In contrast, a layout wherein back surface field regions 26 would be much narrower than the emitter regions 28 would mean that more deposition time and material would be needed.

Preferably, the width of conductor tracks 27 is at least 80% of the width of back surface field regions 26 and emitter regions 28. Preferably, the width of conductor tracks 27 is the same on surface field regions 26 and emitter regions 28

In the cell as shown, back surface field regions 26 and emitter regions 28 have substantially equal width. A width W=1.6 millimeter may be used for example, or more generally, a width in a range of 0.75 to 3 millimeter. An advantage of using back surface field regions 26 and emitter regions 28 with equal width is that conductor tracks 27 of equal width can be used on back surface field regions 26 and emitter regions 28. Also the thickness of conductor tracks 27 can be the same.

If the width of the emitter regions 28 would be made very small, this could reduce efficiency. Narrow emitter regions 28 would allow only small areas for charge carrier flow from the front surface floating emitter to the back surface emitter, and a "base" voltage in the substrate between the front surface floating emitter and the back surface emitter that does not fully facilitate charge carrier flow from the front surface floating emitter and the back surface emitter. Increasing the emitter region width results in a part of the substrate above the emitter region 28 with a "base" voltage that improves vertical minority charge carrier flow from the front surface floating emitter to the back surface emitter (minority charge, that is, of the polarity that is minority charge carrier in the semi-conductor substrate, but majority charge carrier in the front surface floating emitter to the back surface emitter). Back surface emitter regions of equal width as the back surface field regions are preferred. With back surface field regions of more than 0.6 and preferably more than 0.75 or 1 millimeter, the back surface emitter regions preferably at least have widths between 0.2 and 2 times the width of the back surface field regions, and preferably between 0.5 and 1.5.

Figure 3 schematically shows a top view of part of the back surface of the photovoltaic cell not part of the invention, wherein back surface field regions 26 and emitter regions 28 form strips.

The cross-section shown in figure 2, indicated by a dashed line A-A, runs perpendicularly to the longest direction of the strips. The width of the strips is indicated by W. It should be noted that strips are only shown by way of example.

Regions of other shapes, such as squares, hexagons etc, could be used. In practice, the cell will contain other structures (not shown) such. Electrodes (conductor tracks 27) are to be provided on back surface field regions 26 and emitter regions 28, for example midway the strips, running at least substantially along the entire length of the strip, for conducting current from the cell.

In embodiments, a silicon substrate 20 is used, with a thickness of between 50 and 250 micrometer (e.g. 180 micrometer) between front surface 22a and back surface 22b and a resistance of more than 0.012 Ohm meter. In embodiments, back surface field regions 26 have a width W between 0.75 and 3 millimeter. Herein the width W is the side to side distance along the smallest direction of the strips, or more generally the smallest distance between opposite parallel sides between which an electrode is located. In embodiments, back surface field regions 26 and emitter regions 28 have substantially equal width (e.g. less than 10% difference). In embodiments, front floating emitter layer 24 has an electrical conductivity of more than 10 milli-Siemens square conductance. Electrical conductivity depends on doping density in floating emitter layer 24 and the thickness of this layer from the surface to a junction depth (the depth where the doping densities of opposite electrical conductivity types are equal). The process of creation of the layer provides for a relation between doping density and thickness. In practice the thickness may be between 0.5 and 1 micrometer for example. Preferably, substrate 20 is of n-electrical conductivity type silicon, e.g. phosphor doped and the front floating emitter layer 24 is of p-electrical conductivity type, e.g. boron doped.

In prior art back contact photo-voltaic cells with a front floating emitter p-electrical conductivity type substrates are mostly used, with thicker and less resistive substrates (more than 200 micron thick and less than 0.0125 Ohm meter resistivity).

For such p-type substrates, the prior art uses phosphor doped front floating emitters, with resistance values of less than 10 milli-Siemens square. The back surface field regions are less than 0.4 millimeter wide and the emitter regions are at least five times as wide as the back surface field regions in order to reduce the effect of electric shading.

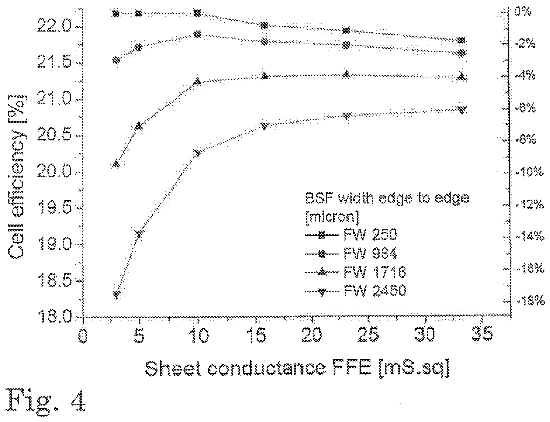

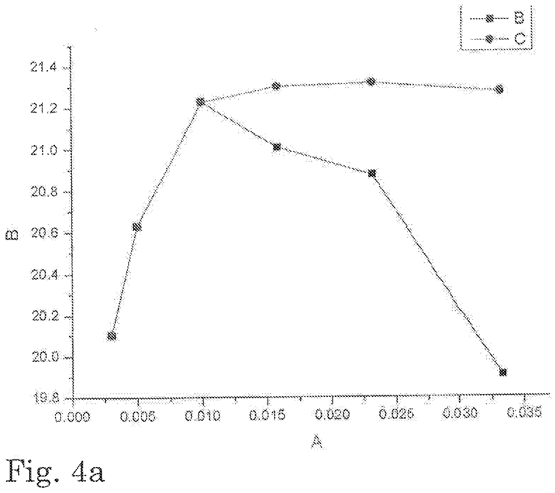

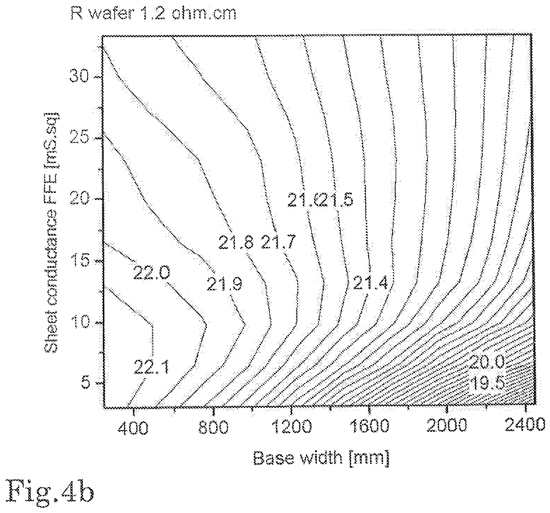

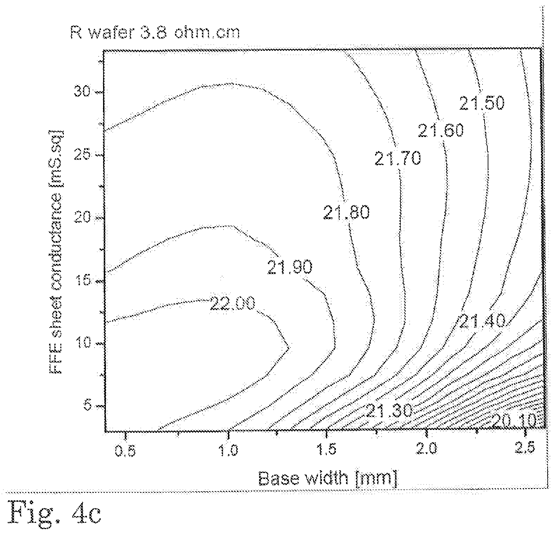

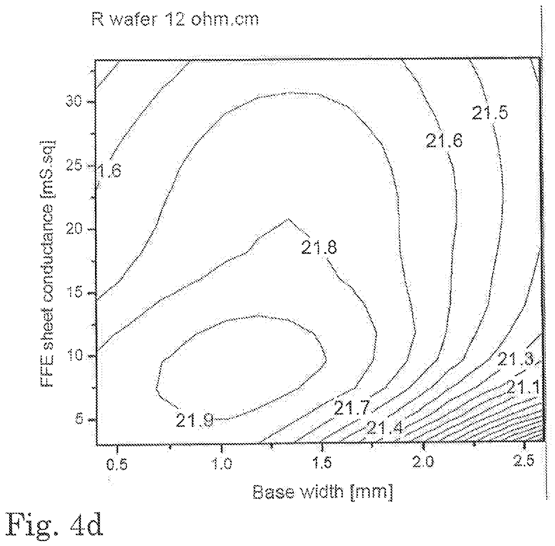

Figure 4 plots of simulated cell efficiency as function of (dark) FFE electrical conductivity values for a number of base widths. The electrical conductivity of the front floating emitter layer 24 is a function of doping of the front floating emitter layer 24 and can be set by adjusting the amount of doping used during manufacture. The plots have been obtained by simulation for cell with n-type silicon substrate with 0.015 Ohm meter resistance, 180 micrometer thickness, back surface emitter width of W=1.6 millimeter, and a gap of 75 micrometer between the base and emitter regions. Front floating emitter depth and doping density vary with electrical conductivity of the front floating emitter layer 24.

In the simulation a passivation that eliminates Shockley Reed Hall recombination was assumed. The residual recombination at the surface is due to Auger recombination which increases with carrier density. In practice, a degree of Shockley Reed Hall recombination is inevitable, the degree of Shockley Reed Hall recombination depending on the manufacturing process. The Shockley Reed Hall recombination will have the effect that efficiency will go down with increasing FFE electrical conductivity for higher FFE electrical conductivity, instead of levelling off as in figure 4.

This is illustrated in figure 4a, which shows plots of cell efficiency (vertically) as a function of FFE electrical conductivity in Siemens square (horizontally) for a cell with a back surface field width of 1.6 millimeter and a substrate with resistivity of 1.2 Ohm cm, without Shockley Reed Hall recombination and with state of the art Shockley Reed Hall recombination values, as function of FFE electrical conductivity.

The circles (C) show the effect without Shockley Reed Hall recombination and the squares (B) show the effect with Shockley Reed Hall recombination. As can be seen, the efficiency will have a maximum as a function of FFE electrical conductivity, the exact position of the maximum being dependent on the manufacturing process.

As shown in figure 4a high efficiency is obtained when the average front floating emitter layer conductance is less than 25 milliSiemens square

Taking account of the elimination of Shockley Reed Hall recombination, the top plot in figure 4 (for a back surface field width of 250 micrometer) confirms the effect shown in figure 1a that optimal efficiency is achieved for small FFE electrical conductivity

The leftmost points in figure 4 confirm the effect shown in figure 1b that, when one starts with an FFE electrical conductivity that is optimal for small back surface field width, the efficiency drops strongly with increased back surface field width.

However, Figure 4 shows that this is not the case when a higher FFE electrical conductivity is used.. For higher FFE electrical conductivity, the loss of efficiency is much less strong. It is found that almost the same efficiency as for narrow back surface field regions can be achieved (20.4% instead of 22.5%) with wider back surface field regions 26 provided that the doping concentration value of the floating front emitter layer 24 is increased in correspondence with the width of the back surface field regions 26.

The threshold doping concentration value needed to avoid strong loss of efficiency shifts upwards with increasing width of the back surface field regions 26. In a band of width-electrical conductivity points on both sides of the line of optimum doping-with concentrations, the efficiency decreases much less with increasing width of surface field regions 26.

Figures 4b-d show contour plots with contours of constant simulated cell efficiency values for a number of different efficiency values at 0.1% spacing in a plane wherein the width of the back surface field regions 26 and the electrical conductivity of the front floating emitter layer 24 are plotted along the horizontal and vertical axes respectively.

Figure 4b-d shows plots for a substrate with bulk resistivities of 1.2 Ohm cm, 3.8 Ohm cm and 12 Ohm cm respectively (0.012, 0.038 and 0.12 Ohm meter). As can be seen from these contour plots, there is a marked qualitative difference in the behavior at the conventional small back surface field region widths of 0.4 millimeter and larger back surface field region widths. Whereas there is already a decrease in efficiency with increased FFE conductivity for small base surface field width even without manufacturing dependent recombination losses, the efficiency keeps increasing or saturates with increased FFE conductivity for back surface field widths of more than about 1.25 millimeter.

As a result, the decrease of efficiency with increasing back surface field width (the density of the contour lines) is much smaller for higher FFE conductivity values above about 10 milliSiemens square (mS.sq) FFE conductivity value.

The discovery that the efficiency hardly decreases with increasing width of the back surface field regions 26, if only one adapts the electrical conductivity value in accordance with the width can be applied by making photo-voltaic cells with larger width back surface field regions 26 than were previously contemplated (e.g. previously up to 400 micrometer wide back surface field regions 26). Widths of at least 600 micrometer, and more preferably more than one 750 micrometer or more than one millimeter and up to two or three millimeter may be used. With a correspondingly adapted front floating emitter electrical conductivity widths of one millimeter lead only to a reduction of efficiency from 22.8% to 22.4% and widths of two millimeter lead only to a reduction of efficiency to 22.1%.

In return, the increased width makes it possible to use conductor tracks 27 of less different width than when conventional narrow back surface fields are used.

Preferably conductor tracks 27 of equal width of the same conductor material are used, for example aluminum. Preferably, back surface field regions 26 and emitter regions of equal width are used, for example both 1.6 millimeter wide or both between one and three millimeter wide.

Empirically it has been found from the simulations that threshold electrical conductivity values C for the front floating emitter layer that avoid strong loss in conductivity satisfy the relation C=a*W-b, wherein W is the width of the back surface field region in millimeters, with coefficients a= 5.54 milliSiemens square/millimeter and b=1.0 milliSiemens square

Further simulation has shown that this band does not substantially change with substrate thickness over a range of 90-180 micrometer, although the values of the efficiency on the contours may be different (e.g. all higher or all lower). Hence, the effect may also be expected outside said range. Similarly, different values of the dark sheet conductivity of the substrate between 1.5 milliSiemens square and 15 milliSiemens square did not change the band, although the values of the efficiencies on the contours may be different. This means that the effect is useful for industrially used substrates where such variations occur. Because of the consistency of the effect it may also be expected outside this range. Similarly, it was found that no substantial change occurred in the dependence on back surface field width and FFE conductivity when the distance between back surface field regions and emitter regions was varied between 75 en 375 micron, although the absolute level of the efficiency changes. Hence, a similar dependence may also be expected outside said range.

Although an example of a silicon substrate has been given, it is expected that a similar effect will occur for other types of substrate. Hence also for such substrates efficiency values near those for cells with narrow back surface field regions are possible if a front floating emitter with an electrical conductivity selected dependent on the width of the back surface field regions is used. The optimal electrical conductivity may be selected by using a given layout of the back surface and determining efficiency values for cells with front floating emitters with different electrical conductivity values. The electrical conductivity value with the best efficiency, or at least no more than a predetermined deviation from the best efficiency (e.g. no more than 0.2% less) may then be used for production.

The length of the back surface field regions 26 (i.e. their size in the direction transverse to the direction along which the width is defined) is not expected to have a significant effect, as long as it is larger than the width, preferably at least twice as large. Although strip shaped areas with straight parallel edges have been shown by way of illustration, it should be appreciated that areas of any other shape may be used, in which case the width W of a back surface field region 26 is defined as twice the distance of a point in the back surface field region 26 to the closest edge of the back surface field region 26, where a point with the largest such distance is used. In principle, a combination of back surface field region 26 with mutually different widths may be used, different parts of the front floating emitter layer 24 having different electrical conductivity in accordance with the width of the underlying back surface field regions 26. Preferably all back surface field regions 26 have the same width, or at most a minority in terms of overall back surface field area has a different width, for example only back surface field regions 26 nearest to the edges of the photo-voltaic cell.

The front floating emitter layer may be created for example by depositing a doping source material (e.g. a boron containing glass in the case of an n-type substrate) on the front surface, followed by a heating step to cause emitter doping to diffuse into the substrate. The electrical conductivity of the front floating emitter layer may be controlled by selection of the temperature of the heating step and/or its duration. The electrical conductivity of the front floating emitter layer may also be adjusted by means of a subsequent etch back step, wherein material is etched from the front surface. In this case, the duration of the etch back step may be set to control a change of the electrical conductivity.

The size of the back surface field regions may be controlled by a patterning process. One example is a screen printing process with a screen pattern corresponding to the desired width. Another process may use photolithography with photo-masks that define the size. For example, back surface field doping source material (e.g. a material containing phosphor in the case of an n-type substrate) may be applied in a pattern to the back surface, followed by a heating step to cause back surface field doping to diffuse into the substrate, thereby locally inverting the net doping polarity in the emitter layer.

A tentative explanation of the source of the effect is that photo-generated minority charge carriers from the bulk of substrate 20 above the back surface field regions 26 migrate to front floating emitter layer 24 and are transported laterally through front floating emitter layer 24 to locations over or near back surface emitter regions 28.

Improved electrical conductivity of the front floating emitter layer 24 increases this effect. The result is a reduction in losses due to electrical shading. This introduces a third effect in the compromise between lower and higher doping levels of front floating emitter layer 24, in addition to the effects of one type charge carrier density suppression and the onset of other recombination mechanisms. As is illustrated by figure 4, it has been found that this shifts the threshold doping levels of front floating emitter layer 24 when wider back surface field regions 26 are used. This can be applied by adjusting the doping level when wide back surface field regions 26 are used.

Figure 5 shows a cross section (not to scale) of an embodiment of a photo-voltaic cell wherein a front surface field layer 50 is provided on top of front floating emitter layer 24 at the front surface. Thus a buried front floating emitter layer 24 is provided.

Front surface field layer 50 and front floating emitter layer 24 have mutually opposite electrical conductivity type. During manufacture, front surface field layer 50 may be created for example by using an additional diffusion step with doping material of the appropriate electrical conductivity type (n or p type dependent on whether an n-type of p-type substrate 20 is used respectively, e.g. phosphor or boron), later than the step wherein the doping of the front floating emitter layer 24 is first diffused. In this embodiment, front surface field layer 50 performs the function of suppressing minority charge carrier density at the surface in order to reduce surface recombination. However, front floating emitter layer 24 still functions to make it possible to use a wider back surface field region when the electrical conductivity of front floating emitter layer 24 is selected in correspondence with the width of the back surface field region. Preferably, vias through the floating emitter layer 24 are provided (regions with the same conductivity type as front surface field layer 50).

When a front surface field layer is used in addition to the front floating emitter, floating emitter layer 24 may be omitted in areas of the front surface that lie above emitter regions at the back surface of the substrate.

Figure 5a shows an embodiment (not to scale) wherein parts of the substrate that form connection openings from the front surface field layer through the front floating emitter layer 24 to the bulk of substrate 20 are provided at locations above back surface field regions 26. The number and size of the openings is illustrative only (not to scale). It should be appreciated that the openings will have a limited size in a direction perpendicular to the plane of the cross-section, so that currents through the front floating emitter to points above the edges of back surface field regions 26 are not prevented. As used herein a connection opening is a part of the substrate wherein the electrical conductivity type remains the same as that in the bulk of substrate up to the front surface. The size of each connection opening is preferably so small that no point in the connection openings is more than the effective diffusion length of the minority charge carriers (e.g. at most one millimeter) away from the edge of the connection openings. The connection openings function to transport photo-generated majority charge carriers from front surface field layer 50 to substrate 20 and from there to back surface field regions 26, thereby increasing efficiency. Connection openings may be created for example by using masked areas on the front surface in one or more steps wherein the front floating emitter layer 24 is created, or by local diffusion of doping at the locations of the connection openings to reverse the net doping polarity in the connection openings.

Furthermore, as shown in figure 5a, large openings may be used over emitter regions 28. Openings over emitter regions 28 and openings over base surface field regions 26 may be used or not independently of one another.

Although the front floating emitter layer 24 may extend as a uniform blanket over the entire front surface of the substrate, this is not necessary.

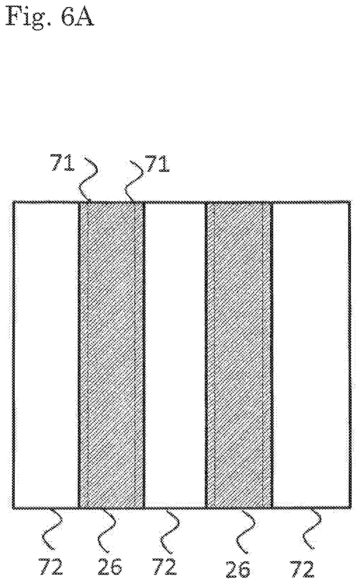

Figure 6a shows an embodiment comprising the front floating emitter layer with locally enhanced doping of the opposite electrical conductivity type compared to the substrate. A top view of the front surface is shown, but back surface field regions 26 and their edges (dashed lines 71) are indicated for reference. On the front surface regions (shown as dashed areas) of relatively higher front floating emitter conductance are provided extending continuously over back surface field regions 26 and beyond their edges 71. Further front regions 72 of relatively lower front floating emitter conductance are provided above part of the back surface emitter regions (not indicated), between the front surface regions with relatively higher front floating emitter conductance. Alternatively, a front floating emitter region may be omitted at the location of these further front regions 72.

If a non-uniform floating emitter layer 24 is used, the average conductivity of the front floating emitter layer 24 above the back surface field regions 26 is preferably set in the band shown in figure 4.

Figure 6 shows an embodiment comprising the front floating emitter layer with locally enhanced doping of the opposite electrical conductivity type compared to the substrate. By way of example, linear strips 50 (also called "lines", only one labeled) are used at least in regions over the back surface field regions 26. Preferably lines 60 extend over a back surface field region 26 at least substantially up to locations above an edge of that back surface field region 26 or beyond, or at least substantially to both opposite edges or beyond. Outside lines 60, the front floating emitter may have a standard electrical conductivity, independent of back surface field width, selected to minimize recombination. Within lines 60, the front floating emitter has an enhanced electrical conductivity, selected dependent on the width of the back surface field regions 26. The average electrical conductivity of lines 60 and the area outside lines (i.e. the sum of wherein their electrical conductivities are weighted by the respective fractions of the front surface that they occupy above the back surface field regions) is preferably within the band shown in figure 4.

Lines 60 need not be straight, nor need they run perpendicularly to the edges. Lines 60 may extend transversely from positions above the edge of a back surface field region into the area above that back surface field region (as used herein transversely includes perpendicularly, but also other angles to the edge provide that the lines reach substantially into the area above the back surface field region, e.g. at least halfway the opposite edge). Lines that extend perpendicularly are preferred. It suffices that they reach at least substantially to the edges or beyond. In this example lines 60 make it possible to use wider back surface field regions. The electrical conductivity in lines 60 may be deviate from the threshold suggested for a blanket layer in figure 4, dependent on the layout, as long as the average conductivity exceeds the threshold. For example, if lines 60 cover no more than half the surface above the back surface field regions, an electrical conductivity of twice the threshold may be used in lines 60. Optimum or near optimum electrical conductivity for lines 60 may be selected by experiment.

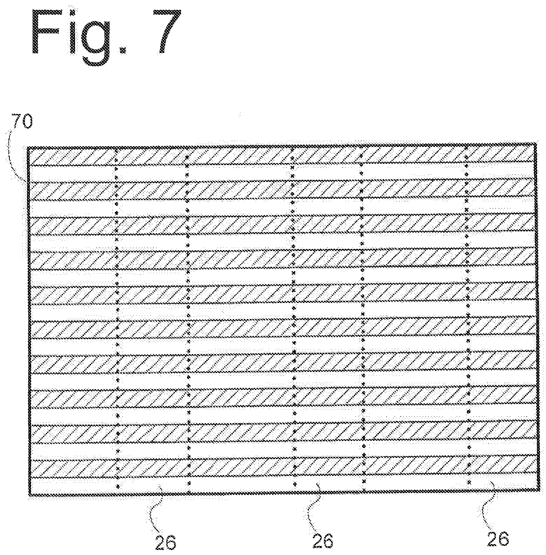

Figure 7 shows a photo-voltaic cell with front surface lines 70 (only one labeled) of enhanced electrical conductivity that extend over both back surface field regions 26 and back surface emitter regions. Here too, the average electrical conductivity of lines 70 and the area outside lines is preferably within the band shown in figure 4.

In another embodiment: not part of the invention front floating emitter layer 24 may be replaced by a front surface field layer, or a mix of front floating emitter regions and front surface field regions, each between the bulk of substrate 20 and the front surface, in parts of the front surface that lie above the emitter regions at the back surface. In these parts front floating emitter layer 24 contributed much less to efficiency. Use of front surface field regions that extend from points above the back surface emitter regions towards the edge of these back surface emitter regions may even increase efficiency by reducing potential gradients above the back surface emitter regions. In a further embodiment a grid of conductors, such as conductors made of a conventional transparent conductive oxide (TCO), or metal conductors may be used. A mix of floating emitter regions and front surface field regions may be created for example by using masked areas on the front surface in one or more steps wherein the front floating emitter layer is created, or by local diffusion of doping at the locations of the connection openings to reverse the net doping polarity in the connection openings.

In an embodiment of a process of manufacturing the photo-voltaic cell comprises creating emitter layers in the substrate adjacent the front surface and the back surface using common steps, in combination with a separate step to create a pattern of back surface field regions at the back surface. This may result in a photo-voltaic cell wherein the front floating emitter and the emitter regions at the back surface have the same doping profile. It has been found that the doping profiles for near optimum results from the front floating emitter can be used for providing effective emitters areas at the back surface.

In an alternative embodiment, the emitter layers at the front surface and the back surface may be created using separate steps. This makes it possible to optimize the front floating emitter doping (as shown in figure 4) and the back surface field doping independently of each other. Also the back surface emitter may be created by a different type of process compared to the back surface emitter regions, the latter being created by depositing an emitter layer on the substrate to form a hetero-junction for example.

## Claims

1. A photo-voltaic cell, comprising a semi-conductor substrate (20), having a front surface and a back surface;
- back surface field regions (26) and emitter regions (28) for collecting photocurrent, located alternatingly at the back surface of the substrate (20), at least one of the back surface field regions (26) having a width of more than six hundred micrometer;
- a front floating emitter layer (24) at the front surface at least above said one of the back surface field regions (26);
- a front surface field layer (50) at the front surface abutting to the front surface, the front floating emitter layer (24) being located between the front surface field layer (50) and a bulk of the substrate (20).

2. A photo-voltaic cell according to claim 1, wherein the front floating emitter layer (24) has an average electrical conductivity with at least an electrical conductivity value C =a*W-b, wherein W is the width of the back surface field region (26) in millimeter, with coefficients a=5.54 milliSiemens square/millimeter and b=1.0 milliSiemens square.

3. A photo-voltaic cell according to any one of the preceding claims, wherein at least a majority of the back surface field regions (26) at the back surface of the substrate have equal widths.

4. A photo-voltaic cell according to any one of the preceding claims, wherein the back surface field regions (26) and the emitter regions (28) have substantially equal width.

5. A photo-voltaic cell according to any one of the preceding claims, comprising conductor tracks (27) of substantially equal width on the back surface field regions (26) and the emitter regions (28).

6. A photo-voltaic cell according claim 1, comprising a connection opening comprising part of the substrate (20) with a net doping of a same conductivity type as the bulk of the substrate (20) and the front surface field layer (50), the connection opening extending through the front surface field layer (50) from the front surface field layer (50) to the bulk of the substrate (20) at a location overlying said one of the back surface field regions (26).

7. A photo-voltaic cell according to any one of the preceding claims, wherein the front surface of the cell comprises first and second regions, the first regions extending from positions over said one of the back surface field regions (26) at least substantially to an edge of said one of the back surface field regions (26) or beyond the edge, the first regions comprising at least part of the floating emitter layer (24) with said first electrical conductivity value selected dependent on the width of said one of the back surface field regions (26), the second regions not comprising the floating emitter layer (24), or a part of the floating emitter layer having second electrical conductivity value that is lower than the first electrical conductivity value.

8. A photo-voltaic cell according to claim 7, wherein the first regions have the form of lines (60) extending transversely from the edge of said one of the back surface field regions (26) to an area over said one of the back surface field regions (26).

9. A photo-voltaic cell according to claim 1, wherein the front floating emitter layer (24) comprises first regions of relatively higher first electrical conductivity value selected dependent on the width of said one of the back surface field regions (26) and second regions of relatively lower second electrical conductivity value, the first regions extending from positions over said one of the back surface field regions (26) at least substantially to an edge of said one of the back surface field regions (26) or beyond the edge, an average of the first and second electrical conductivities equalling said average electrical conductivity.

## Patentansprüche

1. Photovoltaische Zelle, die ein Halbleitersubstrat (20) mit einer Vorderseite und einer Rückseite umfasst;
- Rückseitenfeldbereiche (26) und Emitterbereiche (28) zum Sammeln von Fotostrom, die abwechselnd an der Rückseite des Substrats (20) angeordnet sind, wobei wenigstens einer der Rückseitenfeldbereiche (26) eine Breite von mehr als sechshundert Mikrometer aufweist;
- eine vordere schwimmende Emitterschicht (24) an der Vorderseite wenigstens oberhalb des einen der Rückseitenfeldbereiche (26);
- eine Vorderseitenfeldschicht (50) an der Vorderseite, die an die Vorderseite angrenzt, wobei die vordere schwimmende Emitterschicht (24) zwischen der Vorderseitenfeldschicht (50) und einem Hauptteil des Substrats (20) angeordnet ist.

2. Photovoltaische Zelle nach Anspruch 1,
wobei die vordere schwimmende Emitterschicht (24) eine mittlere elektrische Leitfähigkeit mit wenigstens einem elektrischen Leitfähigkeitswert C =a*W-b aufweist, wobei W die Breite des Rückseitenfeldbereichs (26) in Millimeter ist, mit den Koeffizienten a=5,54 MilliSiemens Square/Millimeter und b=1,0 MilliSiemens Square.

3. Photovoltaische Zelle nach einem der vorhergehenden Ansprüche,
wobei wenigstens ein Großteil der Rückseitenfeldbereiche (26) an der Rückseite des Substrats gleiche Breiten aufweisen.

4. Photovoltaische Zelle nach einem der vorhergehenden Ansprüche,
wobei die Rückseitenfeldbereiche (26) und die Emitterbereiche (28) im Wesentlichen die gleiche Breite aufweisen.

5. Photovoltaische Zelle nach einem der vorhergehenden Ansprüche, mit Leiterbahnen (27) von im Wesentlichen gleicher Breite auf den Rückseitenfeldbereichen (26) und den Emitterbereichen (28).

6. Photovoltaische Zelle nach Anspruch 1, mit einer Verbindungsöffnung, die einen Teil des Substrats (20) mit einer Nettodotierung desselben Leitfähigkeitstyps wie der Hauptteil des Substrats (20) und die Vorderseitenfeldschicht (50) umfasst, wobei sich die Verbindungsöffnung durch die Vorderseitenfeldschicht (50) von der Vorderseitenfeldschicht (50) zum Hauptteil des Substrats (20) an einer Stelle erstreckt, die über dem einen der Rückseitenfeldbereiche (26) liegt.

7. Photovoltaische Zelle nach einem der vorhergehenden Ansprüche,
wobei die Vorderseite der Zelle erste und zweite Bereiche umfasst, wobei sich die ersten Bereiche von Positionen über dem einen der Rückseitenfeldbereiche (26) wenigstens im Wesentlichen zu einer Kante des einen der Rückseitenfeldbereiche (26) oder über die Kante hinaus erstrecken, wobei die ersten Bereiche wenigstens einen Teil der schwimmenden Emitterschicht (24) mit dem ersten elektrischen Leitfähigkeitswert umfassen, der in Abhängigkeit von der Breite des einen der Rückseitenfeldbereiche (26) ausgewählt ist, wobei die zweiten Bereiche die schwimmende Emitterschicht (24) nicht umfassen, oder ein Teil der schwimmenden Emitterschicht einen zweiten elektrischen Leitfähigkeitswert aufweist, der niedriger als der erste elektrische Leitfähigkeitswert ist.

8. Photovoltaische Zelle nach Anspruch 7, wobei die ersten Bereiche die Form von Linien (60) aufweisen, die sich quer von der Kante des einen der Rückseitenfeldbereiche (26) zu einem Bereich über dem einen der Rückseitenfeldbereiche (26) erstrecken.

9. Photovoltaische Zelle nach Anspruch 1, wobei die vordere schwimmende Emitterschicht (24) erste Bereiche mit einem relativ höheren ersten elektrischen Leitfähigkeitswert, der in Abhängigkeit von der Breite des einen der Rückseitenfeldbereiche (26) ausgewählt wird, und zweite Bereiche mit einem relativ niedrigeren zweiten elektrischen Leitfähigkeitswert aufweist, wobei sich die ersten Bereiche von Positionen über dem einen der Rückseitenfeldbereiche (26) wenigstens im Wesentlichen bis zu einer Kante des einen der Rückseitenfeldbereiche (26) oder über die Kante hinaus erstrecken, wobei ein Mittelwert der ersten und zweiten elektrischen Leitfähigkeiten gleich der mittleren elektrischen Leitfähigkeit ist.

## Revendications

1. Cellule photo-voltaïque, comprenant un substrat de semi-conducteur (20), présentant une surface avant et une surface arrière ;
- des régions de champ de surface arrière (26) et régions émettrices (28) pour recueillir du photo-courant, disposées de manière alternée sur la surface arrière du substrat (20), au moins une des régions de champ de surface arrière (26) présentant une largeur supérieure à six cent micromètres ;
- une couche émettrice flottante avant (24) sur la surface avant au moins au-dessus de ladite une des régions de champ de surface arrière (26) ;
- une couche de champ de surface avant (50) sur la surface avant s'adossant à la surface avant, la couche émettrice flottante avant (24) étant disposée entre la couche de champ de surface avant (50) et un volume du substrat (20).

2. Cellule photo-voltaïque selon la revendication 1, dans laquelle la couche émettrice flottante avant (24) présente une conductivité électrique moyenne avec au moins une valeur de conductivité électrique C=a*W-b, dans laquelle W est la largeur de la région de champ de surface arrière (26) en millimètre, avec les coefficients a=5,54 milliSiemens carré/millimètre et b=1,0 milliSiemens carré.

3. Cellule photo-voltaïque selon l'une quelconque des revendications précédentes, dans laquelle au moins une majorité des régions de champ de surface arrière (26) sur la surface arrière du substrat présente des largeurs égales.

4. Cellule photo-voltaïque selon l'une quelconque des revendications précédentes, dans laquelle les régions de champ de surface arrière (26) et les régions émettrices (28) présentent une largeur substantiellement égale.

5. Cellule photo-voltaïque selon l'une quelconque des revendications précédentes, comprenant des pistes de conducteurs (27) de largeur substantiellement égale sur les régions de champ de surface arrière (26) et les régions émettrices (28).

6. Cellule photo-voltaïque selon la revendication 1, comprenant une ouverture de connexion comprenant une partie du substrat (20) avec un dopage net d'un même type de conductivité que le volume du substrat (20) et la couche de champ de surface avant (50), l'ouverture de connexion s'étendant à travers la couche de champ de surface avant (50) à partir de la couche de champ de surface avant (50) jusqu'au volume du substrat (20) à un endroit recouvrant ladite une des régions de champ de surface arrière (26).

7. Cellule photo-voltaïque selon l'une quelconque des revendications précédentes, dans laquelle la surface avant de la cellule comprend des première et seconde régions, les premières régions s'étendant à partir de positions sur ladite une des régions de champ de surface arrière (26) au moins substantiellement jusqu'à un bord de ladite une des régions de champ de surface arrière (26) ou au-delà du bord, les premières régions comprenant au moins une partie de la couche émettrice flottante (24) avec ladite première valeur de conductivité électrique choisie selon la largeur de ladite une des régions de champ de surface arrière (26), les secondes régions ne comprenant pas la couche émettrice flottante (24), ou une partie de la couche émettrice flottante présentant une seconde valeur de conductivité électrique qui est inférieure à la première valeur de conductivité électrique.

8. Cellule photo-voltaïque selon la revendication 7, dans laquelle les premières régions présentent la forme de lignes (60) s'étendant transversalement à partir du bord de ladite une des régions de champ de surface arrière (26) jusqu'à une surface sur ladite une des régions de champ de surface arrière (26).

9. Cellule photo-voltaïque selon la revendication 1, dans laquelle la couche émettrice flottante avant (24) comprend des premières régions de première valeur électrique relativement plus élevée choisie selon la largeur de ladite une des régions de champ de surface arrière (26) et des secondes régions de seconde valeur de conductivité électrique relativement inférieure, les premières régions s'étendant à partir de positions sur ladite une des régions de champ de surface arrière (26) au moins substantiellement jusqu'à un bord de ladite une des régions de champ de surface arrière (26) ou au-delà du bord, une moyenne des première et seconde conductivités électriques étant égale à ladite conductivité électrique moyenne.
